Europäisches Patentamt

European Patent Office

Office européen des brevets

(19)

(11) **EP 1 300 952 A1**

(12) ## DEMANDE DE BREVET EUROPEEN

(43) Date de publication:
**09.04.2003 Bulletin 2003/15**

(51) Int Cl.$^7$: **H03M 13/00**, G06F 11/08

(21) Numéro de dépôt: **02354150.1**

(22) Date de dépôt: **03.10.2002**

(84) Etats contractants désignés:
**AT BE BG CH CY CZ DE DK EE ES FI FR GB GR
IE IT LI LU MC NL PT SE SK TR**
Etats d'extension désignés:
**AL LT LV MK RO SI**

(30) Priorité: **05.10.2001 FR 0112862**

(71) Demandeur: **Stmicroelectronics SA
F-92120 Montrouge (FR)**

(72) Inventeur: **Murillo, Laurent
38240 Meylan (FR)**

(74) Mandataire: **de Beaumont, Michel
Cabinet Michel de Beaumont
1, rue Champollion
38000 Grenoble (FR)**

(54) **Code de détection et/ou de correction d'erreurs à haute efficacité**

(57)     L'invention concerne un procédé pour déterminer r bits de détection d'erreur d'un mot de m bits à coder comprenant l'étape consistant à faire le produit d'un vecteur à m composantes représentatif dudit mot de m bits à coder et d'une matrice de contrôle de parité (M). La matrice de contrôle de parité comporte au moins un couple de lignes complémentaires.

Fig 4A

**Description**

La présente invention concerne les codes de détection et/ou de correction d'erreurs.

Les codes de correction d'erreur ont un effet technique et résolvent un problème technique important. En effet, ils permettent de restituer la valeur d'un ou plusieurs bits erronés, par exemple à la suite d'un stockage ou d'une transmission. On peut même affirmer que, sans eux, tout stockage ou transmission d'informations numériques serait illusoire.

La présente invention concerne en particulier les codes linéaires de type Hamming.

Le code de Hamming est un code de détection et de correction d'erreurs utilisé dans de nombreux domaines. On va d'abord décrire un exemple de code de Hamming et son utilisation en stockage de données dans une mémoire, dans le cas où les données à mémoriser sont sous forme de mots de 16 bits.

Soit X le mot à stocker. X peut être représenté par un vecteur Xe, dont les 16 composantes $X_0$ à $X_{15}$ correspondent aux 16 bits du mot à stocker. Cinq bits de détection d'erreur $C_i$ ($C_0$ à $C_4$) sont obtenus en multipliant une matrice de contrôle de parité H, dite matrice de Hamming, de dimension 5 x 16 par le vecteur Xe, sous forme de vecteur colonne.

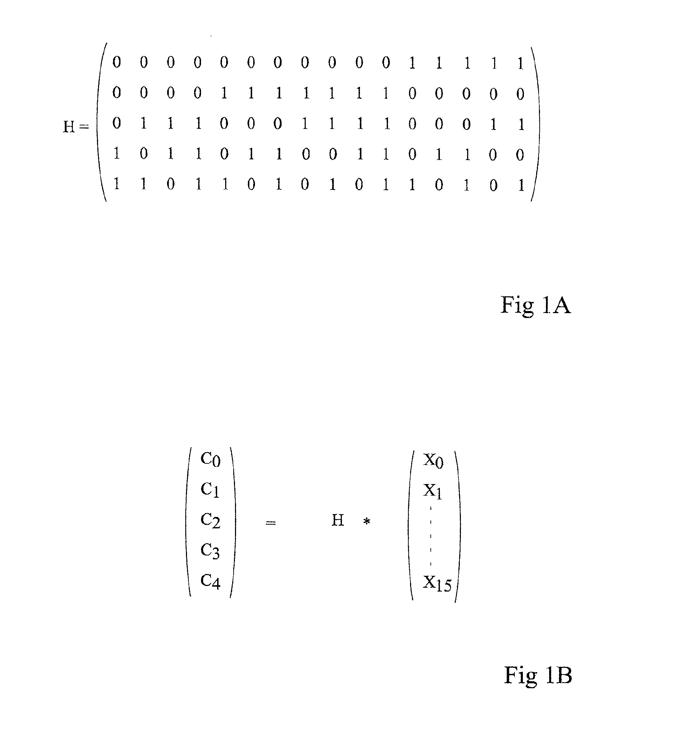

La figure 1A illustre la matrice de Hamming H pour 16 bits et la figure 1B le mode d'obtention des bits de détection. Si l'on appelle $h_{ij}$ les éléments de la matrice H, les bits de détection d'erreur $C_i$ sont donnés par :

$$Ci = \sum_{j=0}^{15} hij.Xj$$

$X_j$ étant la jième composante du vecteur Xe.

En écriture, on inscrit dans la mémoire des mots de 21 bits, formés des 16 bits de données $X_j$ et des 5 bits de détection $C_i$. En lecture, le mot lu comprend 16 bits $X_r$ correspondant aux bits de données et 5 bits $C_r$ correspondant aux bits de détection. $X_r$ et $C_r$ peuvent ne pas être égaux à $X_j$ et $C_i$ si des erreurs ont eu lieu entre les opérations d'écriture et de lecture.

Pour détecter et/ou corriger des erreurs éventuelles sur les bits lus, un syndrome S à cinq composantes S0... S4 est calculé en multipliant une matrice déterminée H' de dimension 5 x 21 par un vecteur colonne à 21 composantes, comprenant les 16 bits $X_r$ et les 5 bits $C_r$.

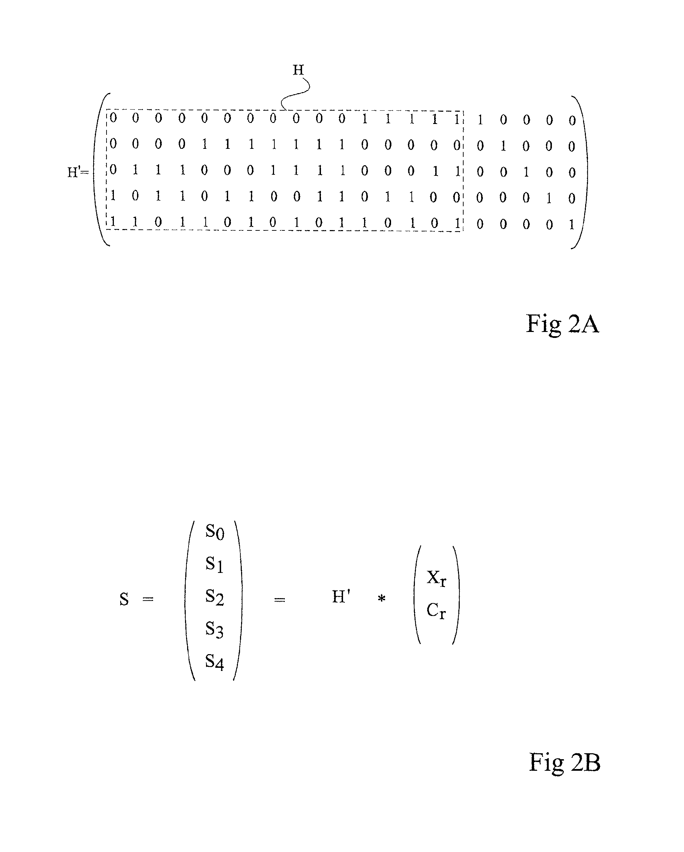

La figure 2A illustre la matrice H'. Les 16 premières colonnes de la matrice H' correspondent aux 16 colonnes de la matrice H. Les 5 colonnes suivantes comprennent chacune un seul "1". La 17ème colonne a son "1" sur la première ligne, la 18ème colonne a son "1" sur la deuxième ligne, et ainsi de suite jusqu'à la 21ème colonne, qui a son "1" sur la cinquième ligne. Les cinq dernières colonnes de la matrice H' servent à déterminer des erreurs éventuelles dans les bits de détection.

La figure 2B illustre le calcul du syndrome S.

Si le syndrome S a toutes ses composantes égales à 0, le stockage a eu lieu sans erreur et tous les bits du mot lu, bits de données ou bits de détection, sont corrects.

Si S est différent de 0, le mot lu comporte une ou plusieurs erreurs. Si un seul bit du mot lu est erroné, le syndrome obtenu permet de corriger l'erreur. En effet, le syndrome correspond dans ce cas à la colonne dont les éléments ont été multipliés par le bit erroné. Ainsi, si le syndrome calculé est égal à :

$$S = \begin{pmatrix} 0 \\ 0 \\ 0 \\ 1 \\ 1 \end{pmatrix},$$

les composantes (00011) du syndrome correspondent aux éléments de la première colonne de la matrice de Hamming et cela signifie que le premier bit, $X_0$, est erroné.

De même, si le syndrome calculé est égal à :

$$S'' = \begin{pmatrix} 1 \\ 0 \\ 0 \\ 0 \\ 0 \end{pmatrix},$$

et qu'il n'y a qu'une seule erreur dans le mot lu, cela signifie que c'est le premier bit de détection $C_0$ qui est erroné.

Le code de Hamming décrit ci-dessus ne peut pas détecter deux erreurs. Ainsi, si une erreur s'est produite sur les bits $X_1$ et $X_2$, le syndrome obtenu est égal à la somme modulo 2 des syndromes correspondant à des erreurs sur X1 et X2, c'est-à-dire à : S''' = (00101) + (00110) = (00011). Le syndrome obtenu indique une erreur sur le bit $X_0$, ce qui est faux.

En effet, on sait que le code de Hamming ci-dessus a une distance minimale de code d = 3 et qu'un code linéaire comme le code de Hamming est capable de corriger L erreurs et de détecter L+1 erreurs si sa distance minimale de code d est strictement supérieure à 2L+1.

Pour améliorer le code ci-dessus et en faire un code ayant une distance minimale de code égale à 4, il est connu d'adjoindre au mot à stocker un bit de parité totale P.

Le bit de parité totale P est calculé en faisant la somme modulo 2 de tous les bits de données et de tous les bits de détection. Le bit de parité totale est ajouté au mot à stocker, et l'ensemble constitué par le mot à stocker, les bits de détection et le bit de parité totale est mémorisé.

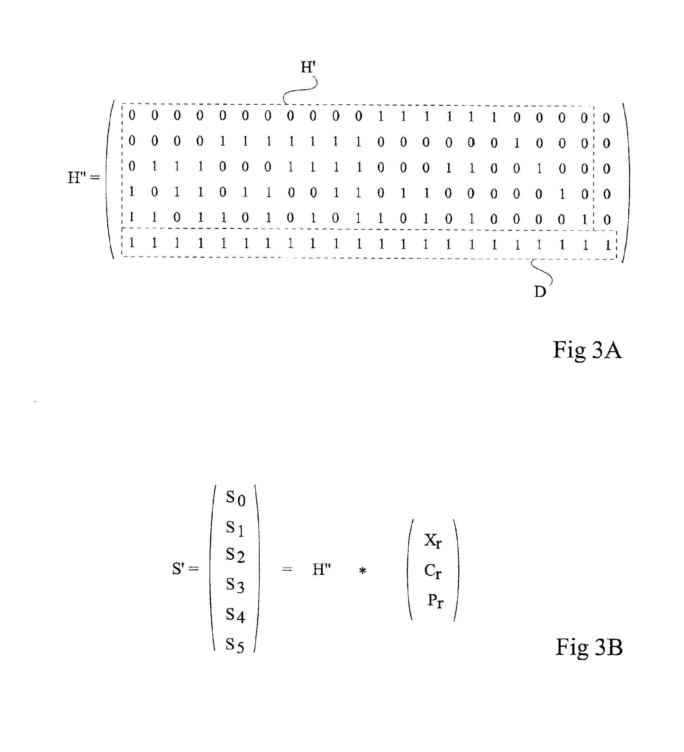

En lecture, le mot lu est multiplié par la matrice de contrôle de parité H'' représentée en figure 3A. La matrice H'' a une ligne et une colonne de plus que la matrice H'. La matrice H'' comporte, en haut et à gauche, c'est-à-dire sur les cinq premières lignes et les 21 premières colonnes, un bloc identique à la matrice H'. La dernière ligne D de la matrice H'' ne comporte que des "1", et la dernière colonne de la matrice H'' ne comporte que des "0", à l'exception de la dernière ligne.

Le syndrome obtenu S' est illustré en figure 3B. Le syndrome S' comporte six composantes S0 à S5, et est obtenu en multipliant la matrice H'' par un vecteur colonne comportant les 22 bits du mot lu, composé des 16 bits de données lus $X_r$, suivis des cinq bits de détection lus $C_r$ et du bit de parité totale lu $P_r$.

Le code ainsi obtenu est un code dit "SEC-DED" ("Single Error Correction" - "Double Error Detection"), signifiant "Correction d'une erreur - Détection de deux erreurs". Ce code a une distance minimale de code égale à quatre et peut détecter deux erreurs dans tous les cas, deux erreurs étant indiquées par le fait que la dernière composante du syndrome, S5, est nulle alors que le syndrome est différent du vecteur nul. Cependant, le code ci-dessus présente plusieurs inconvénients.

Ainsi, au codage, le calcul du bit de parité totale P est nécessaire. Ce calcul nécessite un nombre élevé d'additionneurs, car tous les bits de données et de détection doivent être additionnés modulo 2. En outre, le calcul du bit de parité totale ne peut pas être effectué en parallèle avec le calcul des bits de détection, puisque son calcul nécessite la connaissance préalable des bits de détection. Par conséquent, il faut attendre que tous les bits de détection aient été calculés pour effectuer le calcul du bit de parité totale P, d'où il résulte une perte de temps.

Au décodage, le calcul de la dernière composante du syndrome, S5, nécessite un nombre élevé d'additionneurs, et le circuit de décodage est peu compact. En outre, comme chaque addition dure un certain temps, le calcul de la dernière composante du syndrome a une durée relativement élevée et le décodage n'est pas optimal.

On peut également noter que, dans le code de Hamming décrit ci-dessus, la matrice de Hamming n'est ni symétrique, ni régulière. Ainsi, si l'on considère que les éléments d'une colonne correspondent à la représentation binaire d'un nombre, la variation de ce nombre n'est pas régulière et connaît des sauts. Cela rend difficile la réalisation d'un circuit mettant en oeuvre le code de Hamming ainsi que le décodage du syndrome.

Un objet de la présente invention est de prévoir un code de détection et/ou de correction d'erreurs plus simple que le code de Hamming correspondant.

Un autre objet de la présente invention est de prévoir un procédé et un dispositif pour mettre en oeuvre un tel code de détection et/ou de correction d'erreurs.

Un autre objet de la présente invention est de prévoir un procédé et un dispositif pour mettre en oeuvre un code de détection et/ou de correction d'erreurs qui peut être mis en oeuvre de façon simple par un circuit intégré.

Pour atteindre ces objets ainsi que d'autres, la présente invention prévoit un procédé pour déterminer r bits de détection d'erreur d'un mot de m bits à coder comprenant l'étape consistant à faire le produit d'un vecteur à m composantes représentatif dudit mot de m bits à coder et d'une matrice de contrôle de parité. La matrice de contrôle de parité comporte au moins un couple de lignes complémentaires.

Selon un mode de réalisation de la présente invention, la représentation binaire des r-2 premiers bits de chaque colonne indique le rang de la colonne, à l'exception de la première colonne, de rang 0.

Selon un mode de réalisation de la présente invention, m est un nombre pair, et la matrice de contrôle de parité est telle que :

a) la première moitié de l'avant-dernière ligne, correspondant aux m/2 premières colonnes, comporte un "0" à chaque extrémité et des "1" partout ailleurs,
b) la deuxième moitié de l'avant-dernière ligne, correspondant aux m/2 dernières colonnes, comporte un "1" à chaque extrémité et des "0" partout ailleurs, et
c) la dernière ligne est complémentaire de l'avant-dernière ligne.

Selon un mode de réalisation de la présente invention, deux ou plus de deux lignes et/ou colonnes sont permutées.

Selon un mode de réalisation de la présente invention, le nombre r des bits de détection est égal à n+2, n étant le nombre de bits nécessaire pour représenter, en binaire, le nombre m de bits du mot à coder.

L'invention concerne aussi un procédé de détermination d'un syndrome représentatif d'erreurs éventuelles survenues au cours d'un traitement à un mot de m+r bits, les m+r bits correspondant, avant traitement, à m bits d'un mot à coder et r bits de détection d'erreurs obtenus par un procédé tel que décrit ci-dessus appliqué au mot de m bits à coder, le syndrome étant obtenu au cours d'une étape consistant à multiplier une matrice particulière par un vecteur à m+r composantes représentatives du mot de m+r bits. La matrice particulière comporte :

a) un premier bloc situé à gauche, correspondant à la matrice de contrôle de parité utilisée au codage et ;

b) un deuxième bloc, carré de dimension r-1, en forme de matrice diagonale ne comportant que des "1" sur sa diagonale,

c) une dernière colonne ne comportant que des "0" sur les r-1 premières lignes et un "1" sur la dernière ligne, et

d) sous le deuxième bloc, des éléments inverses de ceux de la dernière ligne du deuxième bloc.

L'invention concerne aussi un code de correction et/ou de détection d'erreur utilisant une matrice telle que définie ci-dessus.

L'invention concerne aussi un circuit de codage permettant la mise en oeuvre d'un code de correction et/ou de détection d'erreur tel que défini ci-dessus, comportant des additionneurs élémentaires, la répartition des additionneurs élémentaires correspondant à la répartition des "1" dans une matrice telle que définie ci-dessus dans le procédé pour déterminer r bits de détection d'erreur.

L'invention concerne aussi un circuit de décodage permettant la mise en oeuvre d'un code de correction et/ou de détection d'erreur tel que défini ci-dessus, comportant des additionneurs élémentaires, la répartition des additionneurs élémentaires correspondant à la répartition des "1" dans une matrice telle que définie ci-dessus dans le procédé de détermination d'un syndrome.

Selon un mode de réalisation de la présente invention, les additionneurs élémentaires sont réalisés par des portes de type OU-Exclusif.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1A et 1B, précédemment décrites, représentent respectivement une matrice de Hamming H et le mode d'obtention de bits de détection pour coder un mot de 16 bits ;

les figures 2A et 2B, précédemment décrites, représentent respectivement une matrice de Hamming H' pour calculer un syndrome et le mode de calcul du syndrome pour un mot de 16 bits ;

les figures 3A et 3B, précédemment décrites, représentent respectivement une matrice de Hamming H" utilisée dans un code permettant de détecter deux erreurs pour des mots de 16 bits et le mode de calcul du syndrome correspondant ;

la figure 4A représente une matrice de contrôle de parité M selon la présente invention pour coder un mot de 16 bits ;

la figure 4B représente une matrice M' utilisée pour calculer un syndrome selon la présente invention ;

la figure 4C représente schématiquement un circuit de décodage pour décoder un mot codé à l'aide de la matrice M ;

la figure 4D représente un élément du circuit de la figure 4C ;

la figure 5A représente une matrice selon la présente invention pour coder un mot de 32 bits ; et

la figure 5B représente une matrice utilisé pour décoder des mots codés à l'aide de la matrice 5A.

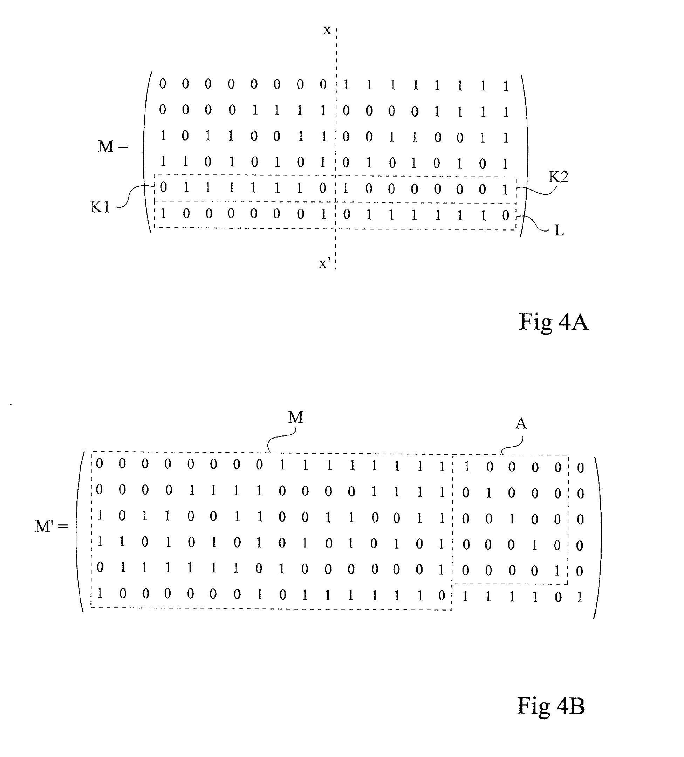

La figure 4A représente une matrice de contrôle de parité M pour calculer des bits de détection pour des mots de 16 bits, dans un code de correction/détection d'erreur selon la présente invention. Le nombre de bits de détection est égal à 6 et la matrice M est de dimension 6 x 16. Chaque colonne de la matrice M est différente d'une autre colonne et les colonnes de la matrice M sont deux à deux linéairement indépendantes.

On élabore la matrice M de la façon suivante. La première colonne de la matrice correspond au rang 0. Pour les autres colonnes, on place, sur les quatre premières lignes, des éléments dont la représentation binaire indique le rang de la colonne. Ainsi, la deuxième colonne, rang 1, comporte, sur les quatre premières lignes, les éléments "0001", représentation binaire du nombre 1. La seizième colonne (rang 15) comporte, sur les quatre première lignes, les éléments 1111, représentation binaire du nombre 15. Les quatre premiers éléments de la première colonne ont été choisis égaux à "0011", qui correspondent aux quatre premiers éléments de la colonne de rang 3. Ce choix n'est pas critique et, pour les quatre premiers éléments de la première colonne, on aurait pu prendre, comme on le verra par la suite, les quatre premiers éléments de n'importe quelle colonne de la matrice M, pourvu que ceux-ci comportent plus d'un seul "1".

Après les quatre premières lignes, on forme la cinquième et avant-dernière ligne de la matrice M. Pour ce faire, la matrice M est partagée en deux par un axe médian xx' séparant les 16 colonnes en 8 colonnes de gauche (rang 0 à 7) et 8 colonnes de droite (rang 8 à 15). La première moitié de la cinquième ligne, correspondant à un bloc K1 de 8 éléments à gauche de l'axe xx', est formée en plaçant un "0" à chaque extrémité du bloc K1 et des "1" partout ailleurs. Ainsi, la première moitié de la cinquième ligne a pour expression "01111110". Pour former la deuxième moitié de la cinquième ligne, correspondant à un bloc K2, on place un "1" à chaque extrémité du bloc K2 et des "0" partout ailleurs. La cinquième ligne a ainsi pour expression complète "0111111010000001".

Les éléments de la dernière et sixième ligne L de la matrice M sont les compléments à deux (ou inverses) des éléments de la cinquième ligne. La ligne L a donc pour expression "1000000101111110".

La matrice M ainsi formée présente des colonnes distinctes et deux à deux linéairement indépendantes. Lorsqu'on multiplie la matrice M par un vecteur colonne de seize composantes correspondant aux bits du mot à coder, on obtient six bits de détection $C_0$-$C_5$, qui sont ajoutés au mot à coder pour former un mot codé de 22 bits. Le décodage du mot codé permet la correction d'une erreur et la détection de deux erreurs.

On notera que la matrice M comporte un couple de lignes, la dernière et l'avant-dernière, qui sont complémentaires l'une de l'autre. Cela procure un avantage important au code de la présente invention. En particulier, le code proposé évite de ce fait le calcul d'un bit de parité totale au codage. Le circuit de codage est plus compact et comporte moins d'additionneurs que dans l'art antérieur. Tous les bits ajoutés au mot à coder peuvent être calculés en parallèle, et il en résulte un gain de temps élevé.

La figure 4B illustre la matrice M' utilisée au décodage. Au décodage, un mot de 22 bits (16 bits de données et 6 bits de détection) est décodé après un traitement quelconque. Par "traitement", on entend une manipulation quelconque du mot à coder, par exemple le stockage dans une mémoire ou la transmission par fil ou voie hertzienne. Le mot à décoder est multiplié par la matrice M' pour former un syndrome à six composantes S0-S5. La matrice M' est une matrice de dimension 6 x 22, comme la matrice H" de la figure 3A. Dans la matrice M', les seize premières colonnes forment un bloc identique à la matrice M. Les cinq premières lignes des cinq colonnes suivantes (rang 16 à 20) forment un bloc A de dimension 5 x 5 constitué par une matrice diagonale ne comprenant que des 1 sur sa diagonale principale et des 0 partout ailleurs. Sous le bloc A, les éléments de la dernière ligne des colonnes de rang 16 à 20 sont choisis égaux à "11110", de façon à correspondre aux inverses des éléments de la dernière ligne du bloc A ("00001"). La dernière colonne de la matrice M', celle qui permet de corriger une erreur sur le sixième bit de détection, comprend des "0" sur les cinq premières lignes et un "1" sur la dernière ligne.

On remarque que, comme pour la matrice M, les deux dernières lignes de la matrice M' sont complémentaires. Ainsi, si l'on fait la somme modulo 2 des deux dernières composantes du syndrome, S4 et S5, on obtient la somme modulo 2 de tous les bits de données et de détection du mot à décoder, c'est-à-dire un bit de parité totale $P_r$, par un calcul simple utilisant sensiblement deux fois moins d'additionneurs et de temps que dans le cas du code de Hamming correspondant. Au décodage, le bit de parité totale $P_r$, obtenu sans le calcul d'un bit de parité totale au codage, est utilisé de la manière suivante.

Si le syndrome obtenu est égal au vecteur nul, il n'y a pas d'erreurs, ni dans les bits de données ni dans les bits de détection.

Si le syndrome obtenu est différent du vecteur nul et le bit de parité totale $P_r$ est égal à 1, cela signifie qu'il y a une seule erreur et elle peut être corrigée. En effet, les composantes du syndrome, dans ce cas, correspondent aux éléments de la colonne de la matrice M' correspondant au bit erroné. En outre, comme les quatre premières composantes du syndrome indiquent le rang du bit erroné à l'exception du premier, il est très facile de déterminer la position du bit erroné et de le corriger. Cela présente un avantage supplémentaire par rapport au code de Hamming.

Si le syndrome est différent du vecteur nul et le bit de parité totale $P_r$ est égal à 0, on se trouve dans le cas de deux erreurs, qui sont détectées.

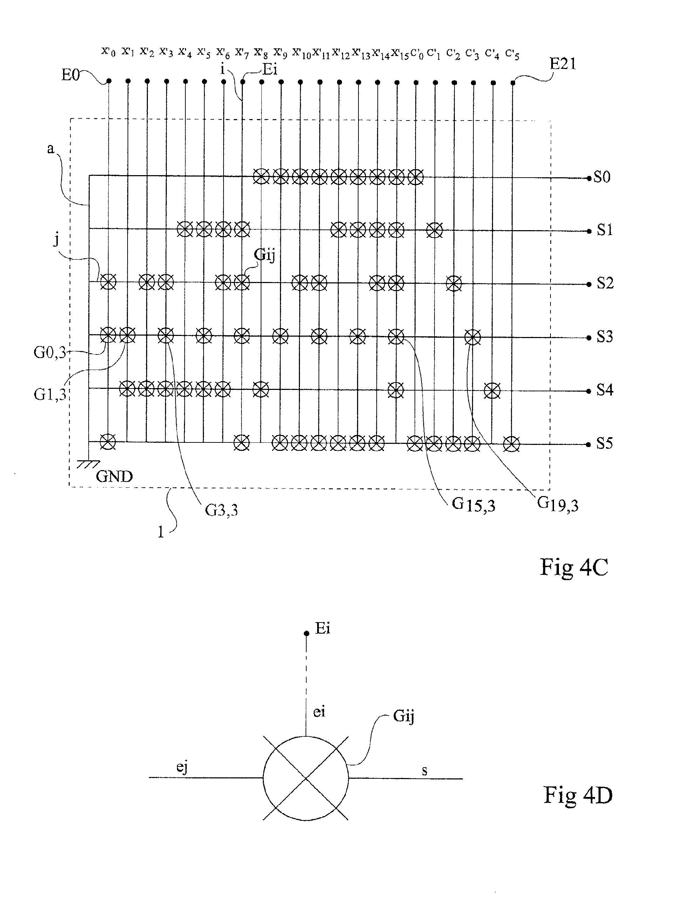

La figure 4C représente schématiquement un circuit 1 pour calculer le syndrome précédent. Sur 22 entrées E0 à E21, le circuit reçoit les 22 bits du mot à coder, à savoir 16 bits de données X'0 à X'15 et 6 bits de détection C'0 à C'5. Le circuit comporte 6 sorties S0 à S5 fournissant les six composantes du syndrome. Chaque entrée Ei est reliée à une colonne de rang i du circuit. Chaque sortie Sj est reliée à une ligne de rang j. A l'intersection de la colonne i et de la ligne j peut se trouver un additionneur modulo 2 $G_{i,j}$ indiqué par un cercle marqué d'une croix. Les additionneurs sont par exemple réalisés par des portes OU-Exclusif.

Comme cela est représenté en figure 4D, l'additionneur Gi,j comporte deux entrées ei et ej. L'entrée ei est reliée à l'entrée Ei et l'entrée ej reçoit le signal présent sur la ligne j à gauche de l'additionneur $G_{i,j}$. L'additionneur $G_{i,j}$ comporte aussi une sortie s située sur la ligne j à droite de l'additionneur $G_{i,j}$.

Lorsqu'il n'y a pas d'additionneur à l'intersection de la colonne i et de la ligne j, cela signifie que la colonne i et la ligne j se croisent sans influence l'une sur l'autre. Cela signifie que le bit fourni à l'entrée concernée n'est pas utilisé pour le calcul de la composante Sj du syndrome.

Une colonne supplémentaire, a, située à gauche de la colonne de rang 0 relie l'entrée ej de chaque premier additionneur d'une ligne à la masse (GND).

Le fonctionnement du circuit de décodage va être expliqué pour le calcul de la composante S3 du syndrome, correspondant à la ligne de rang 3. En partant de la gauche, le premier additionneur rencontré est l'additionneur $G_{0,3}$. L'entrée e3 de l'additionneur $G_{0,3}$ est reliée à la masse et son entrée e0 reçoit le bit de données X'0 par l'intermédiaire de l'entrée E0 du circuit. En sortie de l'additionneur $G_{0,3}$, on a s = 0 ⊕ X'0, c'est-à-dire X'0. Le signal fourni par l'additionneur $G_{0,3}$ attaque l'entrée e3 de l'additionneur $G_{1,3}$, qui effectue le calcul X'0 ⊕ X'1. Le calcul se poursuit ainsi jusqu'à l'additionneur $G_{19,3}$, qui réalise l'addition modulo 2 du résultat fourni par l'additionneur $G_{15,3}$ et du bit de détection C'3. Ainsi, on a :

S3 = X'0 ⊕ X'1 ⊕ X'3 ⊕ X'5 ⊕ X'7 ⊕ X'9 ⊕ X'11 ⊕ X'15 ⊕ C'3,

ce qui correspond bien à la multiplication de la quatrième ligne de la matrice M' par un vecteur ayant pour composantes les bits du mot à décoder. De façon générale, le circuit de décodage de la figure 4C reprend la structure de la matrice M', les lignes et les colonnes du circuit correspondant aux lignes et aux colonnes de la matrice M', un additionneur modulo 2 étant situé là où la matrice M' comporte un 1.

Dans le code décrit en relation avec les figures 4A à 4D, la complémentarité de deux lignes des matrices utilisées rend inutile le calcul d'un bit de parité totale au codage, contrairement à l'art antérieur. Il en résulte un gain de temps et un nombre d'additionneurs réduit. En outre, le motif formé par les additionneurs est assez répétitif, ce qui favorise la réalisation du circuit. Dans le cas d'une erreur, la relation simple entre le rang du bit erroné et les composantes du syndrome simplifie par ailleurs la localisation de l'erreur.

Le circuit utilisé pour le codage n'a pas été représenté. Il correspond au circuit de décodage, à l'exception des six dernières colonnes, inexistantes pour le codage. Les sorties du circuit de codage fournissent les bits de détection.

Bien entendu, il est aisé de généraliser la matrice M de la figure 4A pour coder un nombre pair m quelconque de bits. Le nombre de bits de détection r doit être au moins supérieur de 2 au nombre nécessaire pour représenter, en binaire, le nombre m de bits du mot à coder. De préférence, r sera égal à sa valeur minimale, pour ne pas alourdir le code. Ainsi, lorsque m est égal à 16, il faut quatre bits pour représenter seize possibilités en binaire et r est choisi égal à 6, comme cela a été vu précédemment. Pour m = 32, le nombre de bits de détection est choisi égal à 7, 32 étant égal à $2^5$. Pour m = 128, il faut 9 bits de détection, et ainsi de suite.

Pour généraliser la matrice M, on détermine d'abord le nombre r de bits de détection nécessaires. Ensuite, on construit la matrice Mm servant au codage de sorte que les r-2 premiers éléments de chaque colonne indiquent, sauf pour la première colonne, le rang de la colonne (on rappelle que le rang de la première colonne est 0, et celui de la dernière colonne m-1). Pour former l'avant-dernière ligne, on sépare la ligne en deux parties de m/2 éléments chacune. La première partie de l'avant-dernière ligne (colonnes 0 à [m/2 - 1]) comprend un "0" à chaque extrémité et des "1" partout ailleurs. La deuxième partie de l'avant-dernière ligne (colonnes m/2 à m-1) comprend un "1" à chaque extrémité et des "0" partout ailleurs.

La dernière ligne de la matrice Mm est complémentaire de l'avant-dernière ligne, c'est-à-dire que les éléments de la dernière ligne sont les inverses (ou compléments à 2) des éléments de l'avant-dernière ligne.

Les r-2 premiers éléments de la première colonne de la matrice Mm peuvent être identiques aux r-2 éléments de n'importe quelle colonne, pour autant que les conditions suivantes soient respectées : la première colonne doit être différente de toutes les autres colonnes ; ses quatre premiers éléments doivent comporter au moins deux "1", afin d'être différentes des colonnes de la matrice utilisée au décodage.

Pour former la matrice M'm servant au décodage, on prend d'abord la matrice de contrôle de parité Mm, et on la complète à droite par une sous-matrice carrée R de dimension r x r. La sous-matrice R comprend des "1" sur sa diagonale principale, et des "0" partout ailleurs sauf sur sa dernière ligne, dont les éléments sont les inverses de ceux de l'avant-dernière ligne de la sous-matrice R. La dernière ligne de la sous-matrice R comporte ainsi des "1" partout sauf à l'avant-dernière colonne.

Le code utilisant les matrices Mm et M'm a une distance de code égale à quatre. Il permet de corriger une erreur et de détecter deux erreurs. Au décodage, le syndrome obtenu a r composantes. Un bit de parité totale est obtenu en ajoutant modulo 2 les deux dernières composantes du syndrome.

Si le syndrome est le vecteur nul, il n'y a pas d'erreur. Si le syndrome est différent du vecteur nul et le bit de parité totale est égal à "1", il y a une seule erreur. Cette erreur est aisément corrigée car les r-2 premières composantes du syndrome indiquent le rang du bit erroné, sauf pour le rang 0. Si le syndrome est différent du vecteur nul et le bit de parité totale est égal à "0", l'on est en présence de deux erreurs.

On notera que, comme pour la matrice M', les deux dernières lignes de la matrice M'm sont inverses l'une de l'autre. La somme modulo 2 des deux dernières composantes du syndrome obtenu représentent la somme modulo 2 de chacun des bits de données et des bits de détection, c'est-à-dire un bit de parité totale, obtenu sans qu'il ait été besoin de calculer un bit de parité totale au codage.

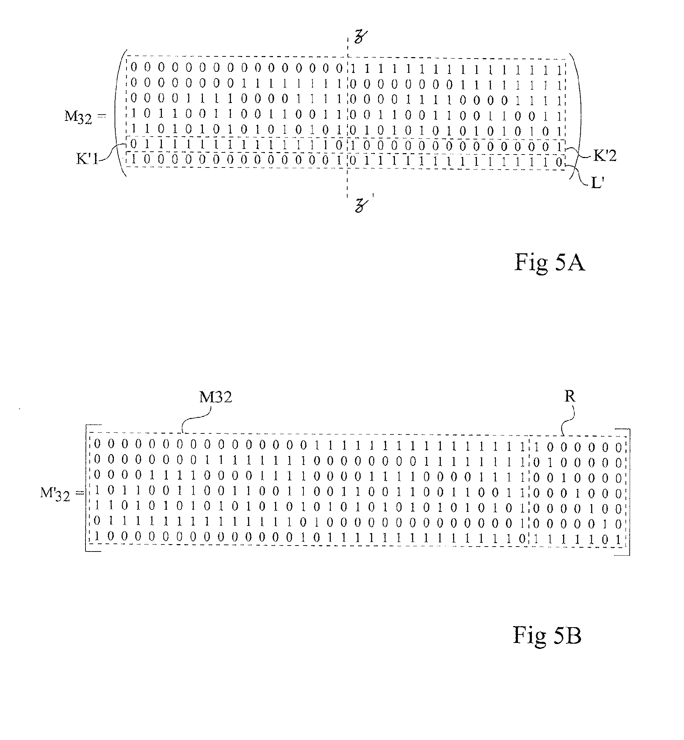

Les figures 5A et 5B représentent respectivement, à titre d'exemple, une matrice M32 utilisée pour coder des mots de 32 bits et la matrice M'32 correspondante utilisée au décodage. La matrice M32 est une matrice de dimension 7 x 32 et la matrice M'32 est une matrice de dimension 7 x 39.

En figure 5A, une droite zz' partage la matrice M32 en deux parties de 16 colonnes chacune. A l'exception de la colonne de rang 0, les cinq premiers éléments de chaque colonne indiquent le rang de la colonne. L'avant-dernière ligne est formée d'un bloc K'1 à gauche de la droite zz' et d'un bloc K'2 à droite de la droite zz'. Le bloc K'1 comprend quatorze "1" encadrés par deux "0", et le bloc K'2 quatorze "0" encadrés par deux "1". Les éléments de la dernière ligne L' sont les inverses des éléments de l'avant-dernière ligne K'1, K'2. Comme pour la matrice M, les 5 premiers éléments de la première colonne de la matrice M32 ("00011") ont été choisis avec deux "1" seulement. Cela présente l'avantage de réduire le nombre des additionneurs, d'où un gain de temps et de place pour les circuits de codage et de décodage.

En figure 5B, la matrice M'32 dérive de la matrice M32 par adjonction, à droite d'un bloc correspondant à la matrice M32, d'un bloc R de dimension 7 x 7 formé suivant les principes généraux énoncés ci-dessus.

Bien entendu, la présente invention est susceptible de diverses variantes et modifications qui apparaîtront à l'homme de l'art. En particulier, les matrices selon la présente invention décrites ci-dessus sont des exemples seulement et l'homme de l'art pourra les modifier aisément. Ainsi, toute permutation de ligne et/ou de colonne d'une matrice selon la présente invention décrite ci-dessus fait partie du domaine de l'invention.

Les deux lignes complémentaires des matrices utilisées ne sont pas nécessairement formées des éléments décrits ci-dessus. Elles ne sont pas non plus nécessairement consécutives.

Aussi, les matrices utilisées au codage et/ou au décodage peuvent posséder plus d'un couple de lignes complémentaires, si cela est souhaité.

Le nombre N de bits du mot à coder peut être pair ou impair, les matrices utilisées au codage et/ou au décodage comprenant au moins un couple de deux lignes complémentaires. Si le nombre N est impair, on peut par exemple d'abord former une matrice Mm telle que décrite ci-dessus avec m pair et égal à N+1. Ensuite, la matrice $M_N$ à utiliser au codage peut dériver aisément de la matrice Mm par suppression d'une colonne quelconque, par exemple la première ou la dernière.

Aussi, la présente invention a principalement été décrite dans le cadre du stockage de mots dans une mémoire. Bien entendu, la présente invention s'applique également à tout codage et décodage de mots auxquels l'on souhaite affecter un code de détection et/ou de correction d'erreur. Par exemple, la présente invention s'applique à la transmission.

**Revendications**

1. Procédé pour déterminer r bits de détection d'erreur ($C_0$, ... $C_{r-1}$) d'un mot de m bits à coder comprenant l'étape consistant à faire le produit d'un vecteur à m composantes représentatif dudit mot de m bits à coder et d'une matrice de contrôle de parité (M, Mm, M32), **caractérisé en ce que** la matrice de contrôle de parité comporte au moins un couple de lignes complémentaires.

2. Procédé selon la revendication 1, dans lequel la représentation binaire des r-2 premiers bits de chaque colonne indique le rang de la colonne, à l'exception de la première colonne, de rang 0.

3. Procédé selon l'une des revendications 1 ou 2, dans lequel m est un nombre pair, et dans lequel la matrice de contrôle de parité est telle que :

   a) la première moitié de l'avant-dernière ligne, correspondant aux m/2 premières colonnes, comporte un "0" à chaque extrémité et des "1" partout ailleurs,

   b) la deuxième moitié de l'avant-dernière ligne, correspondant aux m/2 dernières colonnes, comporte un "1" à chaque extrémité et des "0" partout ailleurs, et

   c) la dernière ligne est complémentaire de l'avant-dernière ligne.

4. Procédé selon l'une des revendications 2 ou 3, dans lequel deux ou plus de deux lignes et/ou colonnes sont permutées.

5. Procédé selon l'une des revendications précédentes, dans lequel le nombre r des bits de détection est égal à n+2, n étant le nombre de bits nécessaire pour représenter, en binaire, le nombre m de bits du mot à coder.

6. Procédé de détermination d'un syndrome représentatif d'erreurs éventuelles survenues au cours d'un traitement à un mot de m+r bits, les m+r bits correspondant, avant traitement, à m bits d'un mot à coder et r bits de détection d'erreurs obtenus par un procédé selon l'une quelconque des revendications 1 à 5 appliqué au mot de m bits à coder, le syndrome étant obtenu au cours d'une étape consistant à multiplier une matrice particulière (M', M'm, M'32) par un vecteur à m+r composantes représentatives du mot de m+r bits, **caractérisé en ce que** la matrice particulière comporte :

   a) un premier bloc situé à gauche, correspondant à la matrice de contrôle de parité utilisée au codage et ;

   b) un deuxième bloc, carré de dimension r-1, en forme de matrice diagonale ne comportant que des "1" sur sa diagonale,

   c) une dernière colonne ne comportant que des "0" sur les r-1 premières lignes et un "1" sur la dernière ligne, et

   d) sous le deuxième bloc, des éléments inverses de ceux de la dernière ligne du deuxième bloc.

7. Procédé pour détecter et/ou corriger des erreurs éventuelles survenues à un mot de m+r bits, comprenant les étapes suivantes :

   a) déterminer un syndrome selon la revendication 6,

   b) si toutes les composantes du syndrome sont nulles, déterminer que le mot de m+r bits ne comporte aucune erreur,

   c) si toutes les composantes du syndrome ne sont pas nulles et que la somme modulo 2 des deux dernières composantes du syndrome est égale à 1, déterminer qu'une seule erreur s'est produite dans le mot de m+r bits, cette erreur pouvant être corrigée à l'aide du syndrome, et

d) si toutes les composantes du syndrome ne sont pas nulles et que la somme modulo 2 des deux dernières composantes du syndrome est égale à 0, déterminer que deux erreurs se sont produites dans le mot de m+r bits.

**8.** Circuit de codage permettant la mise en oeuvre d'un procédé selon l'une quelconque des revendications 1 à 5, comportant des additionneurs élémentaires, la répartition des additionneurs élémentaires correspondant à la répartition des "1" dans une matrice de contrôle de parité (M, Mm, M32) telle que définie dans l'une quelconque des revendications 1 à 5.

**9.** Circuit de décodage permettant la mise en oeuvre d'un procédé selon la revendication 6, comportant des additionneurs élémentaires, la répartition des additionneurs élémentaires correspondant à la répartition des "1" dans une matrice particulière (M', M'm, M'32) telle que définie dans la revendication 6.

**10.** Circuit selon l'une des revendications 8 ou 9, dans lequel les additionneurs élémentaires sont réalisés par des portes de type OU-Exclusif.

$$H = \begin{pmatrix} 0 & 0 & 0 & 0 & 0 & 0 & 0 & 0 & 0 & 0 & 0 & 1 & 1 & 1 & 1 & 1 \\ 0 & 0 & 0 & 0 & 1 & 1 & 1 & 1 & 1 & 1 & 1 & 0 & 0 & 0 & 0 & 0 \\ 0 & 1 & 1 & 1 & 0 & 0 & 0 & 1 & 1 & 1 & 1 & 0 & 0 & 0 & 1 & 1 \\ 1 & 0 & 1 & 1 & 0 & 1 & 1 & 0 & 0 & 1 & 1 & 0 & 1 & 1 & 0 & 0 \\ 1 & 1 & 0 & 1 & 1 & 0 & 1 & 0 & 1 & 0 & 1 & 1 & 0 & 1 & 0 & 1 \end{pmatrix}$$

Fig 1A

$$\begin{pmatrix} C_0 \\ C_1 \\ C_2 \\ C_3 \\ C_4 \end{pmatrix} = H * \begin{pmatrix} X_0 \\ X_1 \\ \vdots \\ \vdots \\ X_{15} \end{pmatrix}$$

Fig 1B

$$H' = \begin{pmatrix}
0 & 0 & 0 & 0 & 0 & 0 & 0 & 0 & 0 & 0 & 0 & 1 & 1 & 1 & 1 & 1 & 1 & 0 & 0 & 0 & 0 \\
0 & 0 & 0 & 0 & 1 & 1 & 1 & 1 & 1 & 1 & 1 & 0 & 0 & 0 & 0 & 0 & 0 & 1 & 0 & 0 & 0 \\
0 & 1 & 1 & 1 & 0 & 0 & 0 & 1 & 1 & 1 & 1 & 0 & 0 & 0 & 1 & 1 & 0 & 0 & 1 & 0 & 0 \\
1 & 0 & 1 & 1 & 0 & 1 & 1 & 0 & 0 & 1 & 1 & 0 & 1 & 1 & 0 & 0 & 0 & 0 & 0 & 1 & 0 \\
1 & 1 & 0 & 1 & 1 & 0 & 1 & 0 & 1 & 0 & 1 & 1 & 0 & 1 & 0 & 1 & 0 & 0 & 0 & 0 & 1
\end{pmatrix}$$

$\overbrace{\qquad\qquad}^{H}$

Fig 2A

$$S = \begin{pmatrix} S_0 \\ S_1 \\ S_2 \\ S_3 \\ S_4 \end{pmatrix} = H' * \begin{pmatrix} X_r \\ C_r \end{pmatrix}$$

Fig 2B

$$H'' = \begin{pmatrix} \overset{H'}{\overbrace{\begin{array}{cccccccccccccccccccccc} 0 & 0 & 0 & 0 & 0 & 0 & 0 & 0 & 0 & 0 & 0 & 0 & 1 & 1 & 1 & 1 & 1 & 1 & 0 & 0 & 0 & 0 \\ 0 & 0 & 0 & 0 & 1 & 1 & 1 & 1 & 1 & 1 & 1 & 0 & 0 & 0 & 0 & 0 & 0 & 0 & 1 & 0 & 0 & 0 \\ 0 & 1 & 1 & 1 & 0 & 0 & 0 & 1 & 1 & 1 & 1 & 0 & 0 & 0 & 1 & 1 & 0 & 0 & 1 & 0 & 0 & 0 \\ 1 & 0 & 1 & 1 & 0 & 1 & 1 & 0 & 0 & 1 & 1 & 0 & 1 & 1 & 0 & 0 & 0 & 0 & 0 & 0 & 1 & 0 \\ 1 & 1 & 0 & 1 & 1 & 0 & 1 & 0 & 1 & 0 & 1 & 1 & 0 & 1 & 0 & 1 & 0 & 0 & 0 & 0 & 0 & 1 \\ 1 & 1 & 1 & 1 & 1 & 1 & 1 & 1 & 1 & 1 & 1 & 1 & 1 & 1 & 1 & 1 & 1 & 1 & 1 & 1 & 1 & 1 \end{array}}} & \begin{array}{c} 0 \\ 0 \\ 0 \\ 0 \\ 0 \\ 1 \end{array} \end{pmatrix}$$

D

## Fig 3A

$$S' = \begin{pmatrix} S_0 \\ S_1 \\ S_2 \\ S_3 \\ S_4 \\ S_5 \end{pmatrix} = H'' * \begin{pmatrix} X_r \\ C_r \\ P_r \end{pmatrix}$$

## Fig 3B

$$
M = \begin{pmatrix}
0 & 0 & 0 & 0 & 0 & 0 & 0 & 0 & 1 & 1 & 1 & 1 & 1 & 1 & 1 & 1 \\
0 & 0 & 0 & 0 & 1 & 1 & 1 & 1 & 0 & 0 & 0 & 0 & 1 & 1 & 1 & 1 \\
1 & 0 & 1 & 1 & 0 & 0 & 1 & 1 & 0 & 0 & 1 & 1 & 0 & 0 & 1 & 1 \\
1 & 1 & 0 & 1 & 0 & 1 & 0 & 1 & 0 & 1 & 0 & 1 & 0 & 1 & 0 & 1 \\
0 & 1 & 1 & 1 & 1 & 1 & 1 & 0 & 1 & 0 & 0 & 0 & 0 & 0 & 0 & 1 \\
1 & 0 & 0 & 0 & 0 & 0 & 0 & 1 & 0 & 1 & 1 & 1 & 1 & 1 & 1 & 0
\end{pmatrix}
\begin{array}{l} \\ \\ \\ \\ \text{K2} \\ \text{L} \end{array}
$$

K1

## Fig 4A

$$
M' = \begin{pmatrix}
0 & 0 & 0 & 0 & 0 & 0 & 0 & 0 & 1 & 1 & 1 & 1 & 1 & 1 & 1 & 1 & 1 & 0 & 0 & 0 & 0 & 0 \\
0 & 0 & 0 & 0 & 1 & 1 & 1 & 1 & 0 & 0 & 0 & 0 & 1 & 1 & 1 & 1 & 0 & 1 & 0 & 0 & 0 & 0 \\
1 & 0 & 1 & 1 & 0 & 0 & 1 & 1 & 0 & 0 & 1 & 1 & 0 & 0 & 1 & 1 & 0 & 0 & 1 & 0 & 0 & 0 \\
1 & 1 & 0 & 1 & 0 & 1 & 0 & 1 & 0 & 1 & 0 & 1 & 0 & 1 & 0 & 1 & 0 & 0 & 0 & 1 & 0 & 0 \\
0 & 1 & 1 & 1 & 1 & 1 & 1 & 0 & 1 & 0 & 0 & 0 & 0 & 0 & 0 & 1 & 0 & 0 & 0 & 0 & 1 & 0 \\
1 & 0 & 0 & 0 & 0 & 0 & 0 & 1 & 0 & 1 & 1 & 1 & 1 & 1 & 1 & 0 & 1 & 1 & 1 & 1 & 0 & 1
\end{pmatrix}
$$

M          A

## Fig 4B

x'$_0$ x'$_1$ x'$_2$ x'$_3$ x'$_4$ x'$_5$ x'$_6$ x'$_7$ x'$_8$ x'$_9$ x'$_{10}$x'$_{11}$x'$_{12}$x'$_{13}$x'$_{14}$x'$_{15}$ c'$_0$ c'$_1$ c'$_2$ c'$_3$ c'$_4$ c'$_5$

E0

i      Ei                                      E21

a

j

Gij

G0,3

G1,3

S0

S1

S2

S3

S4

S5

GND

G3,3              G15,3      G19,3

1

Fig 4C

Ei

ei      Gij

ej                  s

Fig 4D

13

$$M_{32} = \begin{pmatrix} 0 & 0 & 0 & 0 & 0 & 0 & 0 & 0 & 0 & 0 & 0 & 0 & 0 & 0 & 0 & 0 & 1 & 1 & 1 & 1 & 1 & 1 & 1 & 1 & 1 & 1 & 1 & 1 & 1 & 1 & 1 & 1 \\ 0 & 0 & 0 & 0 & 0 & 0 & 0 & 1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 \\ 0 & 0 & 0 & 1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 & 1 & 1 & 1 & 1 \\ 1 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 \\ 1 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 \\ 0 & 1 & 1 & 1 & 1 & 1 & 1 & 1 & 1 & 1 & 1 & 1 & 1 & 1 & 1 & 0 & 1 & 0 & 0 & 0 & 0 & 0 & 0 & 0 & 0 & 0 & 0 & 0 & 0 & 0 & 0 & 1 \\ 1 & 0 & 0 & 0 & 0 & 0 & 0 & 0 & 0 & 0 & 0 & 0 & 0 & 0 & 0 & 1 & 0 & 1 & 1 & 1 & 1 & 1 & 1 & 1 & 1 & 1 & 1 & 1 & 1 & 1 & 1 & 0 \end{pmatrix}$$

K'1 ⸦ ⸨ ⸩ ⸧ K'2

L'

Fig 5A

$$M'_{32} = \begin{pmatrix} 0 & 0 & 0 & 0 & 0 & 0 & 0 & 0 & 0 & 0 & 0 & 0 & 0 & 0 & 0 & 0 & 1 & 1 & 1 & 1 & 1 & 1 & 1 & 1 & 1 & 1 & 1 & 1 & 1 & 1 & 1 & 1 & 1 & 0 & 0 & 0 & 0 & 0 & 0 \\ 0 & 0 & 0 & 0 & 0 & 0 & 0 & 1 & 1 & 1 & 1 & 1 & 1 & 1 & 1 & 0 & 0 & 0 & 0 & 0 & 0 & 0 & 0 & 1 & 1 & 1 & 1 & 1 & 1 & 1 & 1 & 0 & 1 & 0 & 0 & 0 & 0 & 0 \\ 0 & 0 & 0 & 1 & 1 & 1 & 1 & 0 & 0 & 0 & 0 & 1 & 1 & 1 & 1 & 0 & 0 & 0 & 0 & 1 & 1 & 1 & 1 & 0 & 0 & 0 & 0 & 1 & 1 & 1 & 1 & 0 & 0 & 1 & 0 & 0 & 0 \\ 1 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 1 & 1 & 0 & 0 & 0 & 1 & 0 & 0 \\ 1 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 1 & 0 & 0 & 0 & 0 & 1 & 0 \\ 0 & 1 & 1 & 1 & 1 & 1 & 1 & 1 & 1 & 1 & 1 & 1 & 1 & 1 & 1 & 0 & 1 & 0 & 0 & 0 & 0 & 0 & 0 & 0 & 0 & 0 & 0 & 0 & 0 & 0 & 0 & 1 & 0 & 0 & 0 & 0 & 0 & 1 \\ 1 & 0 & 0 & 0 & 0 & 0 & 0 & 0 & 0 & 0 & 0 & 0 & 0 & 0 & 0 & 1 & 0 & 1 & 1 & 1 & 1 & 1 & 1 & 1 & 1 & 1 & 1 & 1 & 1 & 1 & 0 & 1 & 1 & 1 & 1 & 0 & 1 \end{pmatrix}$$

M32      R

Fig 5B

**Office européen des brevets**

# RAPPORT DE RECHERCHE EUROPEENNE

Numéro de la demande

EP 02 35 4150

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 751 744 A (BABB BRENDAN J) 12 mai 1998 (1998-05-12) * figures 1,2,6 * ----- | 1,6,8,9 | H03M13/00 G06F11/08 |

**DOMAINES TECHNIQUES RECHERCHES (Int.Cl.7)**

H03M
G06F

Le présent rapport a été établi pour toutes les revendications

| Lieu de la recherche | Date d'achèvement de la recherche | Examinateur |
|---|---|---|
| LA HAYE | 13 décembre 2002 | Van Staveren, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 02 35 4150

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-12-2002

| Document brevet cité au rapport de recherche | Date de publication | Membre(s) de la famille de brevet(s) | Date de publication |
|---|---|---|---|
| US 5751744 A | 12-05-1998 | AUCUN | |

EPO FORM P0460